# EUROPÄISCHE PATENTANMELDUNG

(11) **EP 0 829 961 A2**
(43) Veröffentlichungstag der Anmeldung: **18.03.1998**
(21) Anmeldenummer: 97112069.6
(22) Anmeldetag: 14.07.1997
(51) Int. Cl.: H03K 5/08

(54) **Schaltung zur Ermittlung und Bewertung eines Datensignals**

(30) Priorität: 12.09.1996 DE 19637150
(71) Anmelder: SIEMENS AKTIENGESELLSCHAFT, 80333 München (DE)
(72) Erfinder: Weber, Stephan, Dr., 81739 München (DE); Thomas, Volker, Dr., 81245 München (DE)

(57) **Zusammenfassung**

Eine Schaltung zur Ermittlung und Bewertung eines Datensignals mit einem störenden Gleichspannungsanteil weist eine Signalbearbeitungseinrichtung auf, mit der der Gleichspannungsanteil ermittelt und dann vom Signal abgezogen wird. Erfindungsgemäß ist eine nichtlineare Steuerung vorgesehen, die abhängig vom Signalverlauf eine Zeitkonstante der Schaltung verändert.

## Beschreibung

Die Erfindung betrifft eine Schaltung zur Ermittlung und BeWertung eines Datensignals, das von einem Gleichspannungsanteil überlagert ist, mit einem Signaleingang, einer Signalbearbeitungseinrichtung, die ein Filter aufweist und einen Teil des Signals weiterleitet, und einer Bewertungseinrichtung, die das ursprüngliche Signal vom Signaleingang mit dem von der Signalbearbeitungseinrichtung weitergeleiteten Teil des Signals vergleicht und das Datensignal ermittelt. Weiterhin betrifft die Erfindung ein Verfahren zur Ermittlung und Bewertung eines Datensignals.

Einem Signal sind bedingt durch Offsetspannungen, Toleranzen usw. oft Gleichspannungen überlagert. Um den Arbeitsbereich der Glieder einer Signalkette optimal ausnutzen zu können, ist es notwendig, diese Gleichspannungen z.B. durch Ermittlung des Gleichspannungsanteils und anschließende Subtraktion zu kompensieren. Gleichspannungsanteile, die auch als Gleichgrößen bezeichnet werden, werden üblicherweise durch Tiefpaßfilterung ermittelt. Ein Beispiel für die Notwendigkeit einer solchen Schaltung ist die Synchronisation in einem TDMA-System (Time Division Multiple Access). Unter einem solchen System versteht man einen Vielfachzugriff im Zeitmultiplexverfahren. Dabei überträgt ein Sender in einer sogenannten Präambel ein Wechselsignal, welches einen Gleichspannungsanteil von Null aufweist. Durch die nichtidealen Eigenschaften in der Sendekette treten am Empfängerausgang zusätzliche Gleichspannungsanteile auf, die kompensiert werden müssen, um eine optimale Übertragungsqualität zu erhalten. Da in einer normalen Datenübertragung auch Gleichspannungsanteile oder besonders niederfrequente Anteile denkbar sind, muß der Gleichspannungsanteil innerhalb der Präambel, die keinen Gleichspannungsanteil aufweist, ermittelt und dann gespeichert werden.

Ein Beispiel für ein solches TDMA-System, in dem sich diese Probleme stellen, ist der neue europäische Schnurlos-Telefonstandard DECT (Digital European Cordless Telephone).

Bei einer bekannten Schaltung wird der Gleichspannungsanteil durch Tiefpaßfilterung ermittelt. Dabei wird hinsichtlich der Filtergrenzfrequenz und der dazu umgekehrt proportionalen Zeitkonstante ein Kompromiß zwischen Geschwindigkeit und Genauigkeit geschlossen. Problematisch ist dabei insbesondere der Schaltpunkt, bei dem von Filterung auf Speicherung umgeschaltet wird, da das System nicht synchronisiert ist. Man kann entweder auf Kosten der Genauigkeit möglichst früh auf Speicherung schalten oder den Übergang von Präambel zu den normalen Daten abwarten. Auch letzteres kann bei Verwendung konventioneller linearer Filter nur mit begrenzter Genauigkeit erfolgen, da die Umschaltung erst mit einer deutlichen Verspätung erkannt werden kann. In diesem Fall erfolgt die Mittelwertbildung auch über einen Teil der Daten, deren Mittelwert aber nicht Null sein muß. Je später die Erkennung des Endes der Präambel und das Umschalten auf Speicherung erfolgt, desto fehlerhafter wird die Mittelwertermittlung. In einem bekannten Lösungsansatz wird die Verzögerung durch Mittelwertbildung nicht des aktuellen Signals sondern eines verzögerten Signals gelöst. Hierfür werden einfache RC-Glieder verwendet. Die Sprungantwort solcher Filter hat immer einen monotonen Charakter, d.h., daß das Signal nach Ende der Präambel systematisch in eine Richtung wegläuft und so einen unter Umständen erheblichen Haltefehler verursacht. Dieser Fehler wird bei Filtern hoher Ordnung kleiner, verschwindet aber nicht völlig.

Der Erfindung liegt die **Aufgabe** zugrunde, eine Schaltung der eingangs genannten Art und ein Verfahren zu schaffen, mit denen ein Signalmittelwert auf besonders präzise und zuverlässige weise ermittelt und gespeichert werden kann.

Die Lösung dieser Aufgabe erfolgt dadurch, daß die Signalbearbeitungseinrichtung eine Zeitkonstanten-Steuereinrichtung aufweist, die in Abhängigkeit von dem Signal hinter dem Filter gesteuert ist.

Insgesamt gesehen wird durch die neue Lösung eine nichtlineare Offset-Erfassung durchgeführt, bei der das Signal hinter dem Filter ausgewertet wird, um in Abhängigkeit von diesem Signal eine große oder eine kleine Zeitkonstante in der Signalbearbeitungseinrichtung einzustellen.

Prinzipiell ist es möglich, die Schaltung so aufzubauen, daß das Filter der Signalbearbeitungseinrichtung ein Hochpaß ist. Bevorzugt ist jedoch die Verwendung eines Tiefpaßes in der Signalbearbeitungseinrichtung, so daß in der Bewertungseinrichtung das von der Signalbearbeitungseinrichtung ermittelte Signal von dem Eingangssignal abgezogen werden kann. Die Signalbearbeitungseinrichtung weist weiterhin bevorzugt eine Track&Hold-Schaltung (Folgen und Halten) auf, in der der ermittelte Gleichspannungsanteil gespeichert werden kann. Die Track&Hold-Schaltung ist grundsätzlich vergleichbar mit einer Sample- und Holdschaltung.

Weiterhin ist am Signaleingang bevorzugt ein Pufferverstärker vorgesehen, mit dem die ankommenden Signale verstärkt werden können. Die Bewertungseinrichtung weist bevorzugt einen Komparator auf, mit dem sich die Signalkompensation besonders leicht durchführen läßt.

In einer bevorzugten Ausbildungsform der Erfindung weist die Zeitkonstanten-Steuereinrichtung einen steuerbaren Widerstand auf. Dieser ist besonders einfach realisierbar und gleichzeitig in die Track&Hold-Schaltung integriert. Weiterhin weist die Zeitkonstanten-Steuereinrichtung bevorzugt eine Steuereinheit auf, die eine Differenzspannung auswertet und eine Verbindung zu dem steuerbaren Widerstand aufweist. Ist beispielsweise die Spannungsdifferenz zwischen dem Filterausgang und dem Ausgang der Track&Hold-Schaltung groß, so steuert die Steuereinheit den steuerbaren Widerstand so an, daß dieser klein ist. Daraus ergibt sich eine kleine Zeitkonstante in der Signalbearbeitungseinrichtung und damit eine hohe Geschwindigkeit.

Bei kleinen Spannungsdifferenzen sorgt die Steuereinheit dafür, daß der steuerbare Widerstand groß ist, um eine hohe Genauigkeit und eine hohe Verzögerung zu erzielen.

Die Steuereinheit weist dazu bevorzugt einen Speicher zum Speichern einer Vergleichsspannung auf. Mit dieser Vergleichsspannung wird die an der Steuereinheit festgestellte Spannung verglichen und beispielsweise bei kleinerer gemessener Spannung der Widerstand auf Groß gestellt. Mathematisch gesehen wird bei dieser Lösung die Zeitkonstanten-Steuereinrichtung mit einer Stufen- oder Sprungfunktion betrieben. Es ist jedoch auch ein stetiger nichtlinearer Zusammenhang möglich, um die erfindungsgemäße Schaltung zu betreiben.

In einer Weiterbildung der Erfindung sind insbesondere die Zeitkonstanten-Steuereinrichtung und die Track&Hold-Schaltung oder sogar die gesamte Schaltung auf einem Chip integriert, da dann keine zusätzliche Anschlüsse oder externen Bauelemente benötigt werden. Weiterhin ist bevorzugt eine Einstelleinrichtung vorgesehen, mit der die Vergleichsspannung geändert oder neu eingestellt werden kann, so daß noch im Betrieb eine Optimierung durchgeführt werden kann.

Erfindungsgemäß wird die bisher beschriebene Schaltung mit einem Verfahren betrieben, bei dem mit einer Steuereinheit eine Differenzspannung gemessen wird und eine ZeitkonstantenSteuer-einrichtung nicht linear angesteuert wird, um bei kleinen Differenzspannungen eine große Zeitkonstante und bei großen Differenzspannungen eine kleine Zeitkonstante zu erzielen.

Durch die Tiefpaßfilterung ist der Wechselanteil am Filterausgang nur noch gering und im stationären Zustand, also bei konstantem Gleichspannungsanteil, der abgeglichen wird, ist die Differenz U_{D} zwischen dem Filterausgang und der Track&Hold-Stu-fe Null. Dieser Zusammenhang wird dazu genutzt, die Zeitkonstante der Track&Hold-Schaltung signalabhängig zu gestalten. Bei einer großen Differenz U_{D} ist die Zeitkonstante klein, um eine hohe Geschwindigkeit zu erzielen und bei kleinen Differenzspannungen ist die Zeitkonstante groß, um eine hohe Genauigkeit und eine hohe Verzögerung zu erzielen.

Nachfolgend wird die Erfindung anhand eines in der Zeichnung dargestellten Ausführungsbeispiels weiter erläutert. Im einzelnen zeigen die schematischen Darstellungen in
- Fig. 1: ein Prinzipschaltbild einer erfindungsgemäßen Schaltung, und
- Fig. 2: ein Diagramm einer Sprungantwort einer erfindungsgemäßen Schaltung im Vergleich mit ande ren Spannungsverläufen.

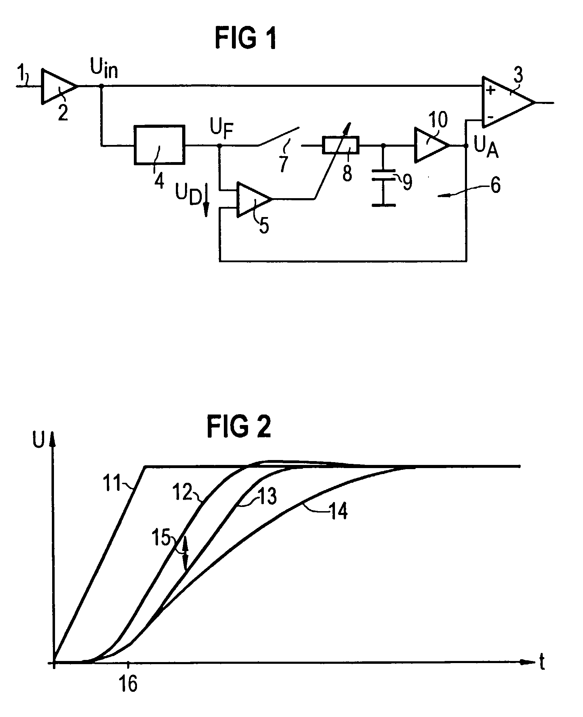

In Fig. 1 ist ein Blockschaltbild einer erfindungsgemäßen Schaltung dargestellt. Am Signaleingang 1 ist ein Pufferverstärker 2 angeordnet, der direkt mit dem positiven Eingang eines Komparators 3 verbunden ist. Hinter dem Pufferverstärker 2 zweigt eine parallele elektrische Verbindung zum negativen Eingang des Komparators 3 ab. In dieser-Verbindung ist die Signalbearbeitungseinrichtung angeordnet, die einen Tiefpaßfilter 4 und eine Track&Hold-Schaltung 6 aufweist, die in Reihe geschaltet sind. Die Track&Hold-Schaltung 6 weist ein Schaltelement 7, einen dazu in Reihe geschalteten Widerstand 8 und einen Verstärker 10 auf. Zwischen dem Widerstand 8 und dem Verstärker 10 liegt ein gegen Masse geschalteter Kondensator 9.

Eine Zeitkonstanten-Steuereinrichtung weist den in die Track&Hold-Schaltung 6 integrierten Widerstand 8 auf, der zur Wahrnehmung seiner Funktion in der Zeitkonstanten-Steuereinrichtung variabel ist. Der steuerbare Widerstand 8 wird durch eine Steuereinheit 5 gesteuert, die ebenfalls Bestandteil der Zeitkonstanten-Steuereinrichtung ist. Die Steuereinheit 5 mißt eine Spannungsdifferenz über der Track&Hold-Schaltung 6 und ist dazu hinter dem Tiefpaßfilter 4 angeschlossen, so daß hier die Filterausgangsspannung U_{F} anliegt, und andererseits hinter der Track&Hold-Schaltung mit der Ausgangsspannung U_{A} angeschlossen.

In Fig. 2 ist eine Sprungantwort einer erfindungsgemäßen Schaltung im Vergleich mit anderen Spannungsverläufen grafisch dargestellt. Dabei ist auf der X-Achse die Zeit und auf der Y-Achse die Spannung aufgetragen. Die Kurve 11 gibt den Verlauf der Eingangsspannung Uᵢₙ wieder, die hinter dem Pufferverstärker 2 gemessen wird. Die Kurve 12 gibt die hinter dem Tiefpaßfilter 4 gemessene Spannung U_{F} wieder. Die Kurve 14 zeigt den Spannungsverlauf einer konventionellen Schaltung mit einem linearen Filter ohne Zeitkonstanten-Steuereinrichtung U_{A} im Bereich hinter der Track&Hold-Schaltung.

Wie anfangs ausgeführt, erfolgt die Umschaltung und Speicherung in der Track&Hold-Schaltung 6 erst nach einer bestimmten Zeitverzögerung. Dies kann beispielsweise zu einem Zeitpunkt erfolgen, der in der Zeichnung mit 16 markiert ist. Hier zeigt sich deutlich der Vorteil der Schaltung der Kurve 14 mit einem linearen Filter gegenüber dem Spannungsverlauf direkt hinter dem Tiefpaßfilter 4. Je größer die schaltungsbedingte Abweichung von einem Spannungswert Null zum Umschaltzeitpunkt ist, desto größer ist der Fehler. Der Nachteil der konventionellen Schaltung, die durch den Verlauf der Kurve 14 wiedergegeben ist, zeigt sich dann im weiteren Verlauf, in dem die Spannung nur langsam den Endwert erreicht.

Demgegenüber führt die erfindungsgemäße Schaltung zu einem Spannungsverlauf, der mit 13 bezeichnet ist. Durch die erfindungsgemäße nichtlineare Filterung erhält man in jedem Zeitbereich die bestmögliche Spannungsantwort. Der mit 15 gekennzeichnete Pfeil zeigt an, daß zwischen den Kurven 12 und 13 ein fast konstanter Abstand herrscht, da die Zeitkonstante in diesem Bereich klein ist.

## Patentansprüche

1. Schaltung zur Ermittlung und Bewertung eines Datensignals, das von einem Gleichspannungsanteil überlagert ist, mit einem Signaleingang (1), einer Signalbearbeitungseinrichtung, die ein Filter (4) aufweist und einen Teil des Signals weiterleitet und einer Bewertungseinrichtung, die das ursprüngliche Signal vom Signaleingang (1) mit dem von der Signalbearbeitungseinrichtung weitergeleiteten Teil des Signals vergleicht und das Datensignal ermittelt,
**dadurch gekennzeichnet,**
daß die Signalbearbeitungseinrichtung eine Zeitkonstanten-Steuereinrichtung aufweist, die in Abhängigkeit von dem Signal hinter dem Filter (4) gesteuert ist.

2. Schaltung nach Anspruch 1,
**dadurch gekennzeichnet,**
daß die Signalbearbeitungseinrichtung einen Tiefpaß (4) aufweist.

3. Schaltung nach einem der Ansprüche 1 oder 2,
**dadurch gekennzeichnet,**
daß die Signalbearbeitungseinrichtung eine Track&Hold-Schaltung (6) aufweist.

4. Schaltung nach einem der vorhergehenden Ansprüche,
**dadurch gekennzeichnet,**
daß am Signaleingang (1) ein Pufferverstärker (2) vorgesehen ist.

5. Schaltung nach einem der vorhergehenden Ansprüche,
**dadurch gekennzeichnet,**
daß die Bewertungseinrichtung einen Komparator (3) aufweist.

6. Schaltung nach einem der vorhergehenden Ansprüche,
**dadurch gekennzeichnet,**
daß die Zeitkonstanten-Steuereinrichtung einen steuerbaren Widerstand (8) aufweist.

7. Schaltung nach einem der vorhergehenden Ansprüche,
**dadurch gekennzeichnet,**
daß die Zeitkonstanten-Steuereinrichtung eine Steuereinheit (5) aufweist, die eine Differenzspannung auswertet und eine Verbindung zu dem steuerbaren Widerstand (8) aufweist.

8. Schaltung nach Anspruch 7,
**dadurch gekennzeichnet,**
daß die Steuereinheit (5) einen Speicher zum Speichern einer Vergleichsspannung aufweist.

9. Schaltung nach einem der vorhergehenden Ansprüche,
**dadurch gekennzeichnet,**
daß die gesamte Schaltung und insbesondere die Track&Hold-Schaltung (6) und die Zeitkonstanten-Steuereinrichtung auf einem Chip integriert sind.

10. Verfahren zum Betrieb einer Schaltung nach einem der vorhergehenden Ansprüche,
**dadurch gekennzeichnet,**
daß mit einer Steuereinheit (5) eine Differenzspannung gemessen wird, und
eine Zeitkonstanten-Steuereinrichtung nichlinear angesteuert wird, um bei kleinen Differenzspannungen eine große Zeitkonstante und bei großen Differenzspannungen eine kleine Zeitkonstante einzustellen.
